# EUROPEAN PATENT APPLICATION

(11) **EP 1 482 576 A2**
(43) Date of publication of application: **01.12.2004**
(21) Application number: 04253063.4
(22) Date of filing: 25.05.2004
(51) Int. Cl.: H01L 51/30

(54) **Hole transport material and method of manufacturing the hole transport material**

(30) Priority: 29.05.2003 JP 2003153539; 08.08.2003 JP 2003206953
(71) Applicant: SEIKO EPSON CORPORATION, Shinjuku-ku, Tokyo 163-0811 (JP)
(72) Inventor: Shinohara, Yuji, Suwa-shi Nagano-ken 392-8502 (JP); Ishii, Ryuji, Suwa-shi Nagano-ken 392-8502 (JP); Shimazu, Masamitsu, Suwa-shi Nagano-ken 392-8502 (JP); Uehara, Masamitsu, Suwa-shi Nagano-ken 392-8502 (JP)
(74) Representative: Kenyon, Sarah Elizabeth

(57) **Abstract**

In an organic EL device, when a voltage is applied across an anode and a cathode, holes are moved in a hole transport layer and electrons are moved in an electron transport layer, and the holes and the electrons are recombined in a light emitting layer. In the light emitting layer, excitons are produced by energy released upon the recombination, and the excitons release energy in the form of fluorescence or phosphorescence or emit light when returning to the ground state. The hole transport material is used in the hole transport layer, in which the amount of cationic impurities and/or the amount of anionic impurities are controlled to be small, so that the decrease of light-emission luminance of the organic EL device is suppressed and excellent light emitting properties are maintained for a long period of time.

## Description

### BACKGROUND OF THE INVENTION

### Field of the Invention

The present invention relates to a hole transport material to be used for a layer having the function of transporting holes in an organic electroluminescent device (element), and a method of manufacturing the hole transport material.

### Description of the Prior Art

There is known an organic electroluminescent device (hereinafter, referred to as an "organic EL device"). The organic EL device has a structure in which at least one light emitting organic layer (organic electroluminescent layer) is provided between a cathode and an anode. Such an organic EL device can significantly reduce a voltage to be applied as compared with an inorganic EL device. Further, it is also possible to manufacture devices that can provide various luminescent colors.

Currently, in order to obtain higher-performance organic EL devices, various researches are being actively carried out in developments and improvements of materials to be used as well as device structures thereof.

Up to now, organic EL devices that can provide various luminescent colors or organic EL devices that have high luminance and high efficiency have been already developed, and in order to realize their various practical uses such as application to a picture element of a display or a light source, further researches are being carried out.

However, from the viewpoint of practical use, the existing organic EL devices still have a problem in that light-emission luminance thereof is decreased or deteriorated when it is used over a long period of time, and therefore there is a demand for the establishment of technical measures to solve the problem.

As for a method for suppressing the decrease of light-emission luminance of an organic EL device, a method using a high-purity organic compound has been proposed (see Japanese Patent Laid-open No. 2002-175885, for example). Japanese Patent Laid-open No. 2002-175885 discloses an organic EL device, in which the content of a halogen-containing compound (impurities) contained in a material constituting the device is made less than 1,000 ppm, thereby suppressing decrease of light-emission luminance which will occur when it is used over a long period of time.

However, specific indexes of the relationship between the decrease of light-emission luminance in an organic EL device and the kinds of impurities contained in the constituent materials to be used and their amounts contained therein have not yet been established. Thus, further researches are being made toward realizing the practical use.

### SUMMARY OF THE INVENTION

It is therefore an object of the present invention to provide a hole transport material which can suppress the decrease of light-emission luminance in an organic EL device, and a method of manufacturing the hole transport material.

In order to achieve the object, the present invention is directed to a hole transport material to be used for a layer having the function of transporting holes in an organic EL device, in which the hole transport material is characterized in that when the layer is formed using the hole transport material, an amount of sulfate ions contained in the layer is 1000 ppm or less.

According to the invention described above, it is possible to provide a hole transport material by which the decrease of light-emission luminance of an organic EL device can be suppressed.

In the above hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

The present invention is also directed to a hole transport material to be used for a layer having the function of transporting holes in an organic EL device, the layer containing one or more kinds of anionic impurities other than sulfate ions, wherein the hole transport material is characterized in that when the layer is formed using the hole transport material, an amount of the anionic impurity of which content is the largest among the anionic impurities is 100 ppm or less.

According to the invention described above, it is also possible to provide a hole transport material by which the decrease of light-emission luminance of an organic EL device can be suppressed.

In this case, it is preferred that the total amounts of the anionic impurities contained in the layer is 500 ppm or less. This makes it possible to more reliably suppress the decrease of light-emission luminance of an organic EL device.

Further, in the above mentioned hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, f luorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

The present invention is also directed to a hole transport material to be used for a layer having the function of transporting holes in an organic EL device, the layer containing one or more kinds of cationic impurities, wherein the hole transport material is characterized in that when the layer is formed using the hole transport material, an amount of the cationic impurity of which content is the largest among the cationic impurities is 500 ppm or less.

According to the invention described above, it is also possible to provide a hole transport material by which the decrease of light-emission luminance of an organic EL device can be suppressed.

In this case, it is preferred that the total amounts of the cationic impurities contained in the layer is 1500 ppm or less. This makes it possible to more reliably suppress the decrease of light-emission luminance of an organic EL device.

Further, it is preferred that the cationic impurities include metal ions. By removing the metal ions, it possible to provide a hole transport material that can more reliably suppress the decrease of light-emission luminance of an organic EL device.

Further, in the above mentioned hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

The present invention is also directed to a hole transport material to be used for a layer having the function of transporting holes in an organic EL device, wherein the hole transport material is characterized in that when the hole transport material is dissolved or dispersed in a liquid so that the concentration thereof becomes 2.0 wt%, the liquid contains sulfate ions, but an amount of the sulfate ions is 20 ppm or less.

According to the invention described above, it is also possible to provide a hole transport material by which the decrease of light-emission luminance of an organic EL device can be suppressed.

In the above hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

The present invention is also directed to a hole transport material to be used for a layer having the function of transporting holes in an organic EL device, wherein the hole transport material is characterized in that when the hole transport material is dissolved or dispersed in a liquid so that the concentration thereof becomes 2.0 wt%, the liquid contains one or more kinds of anionic impurities other than sulfate ions, but an amount of the anionic impurity of which content is the largest among the anionic impurities is 2 ppm or less.

According to the invention described above, it is also possible to provide a hole transport material by which the decrease of light-emission luminance of an organic EL device can be suppressed.

In this case, it is preferred that the total amounts of the anionic impurities contained in the liquid is 10 ppm or less. This makes it possible to more reliably suppress the decrease of light-emission luminance of an organic EL device.

Further, in the above mentioned hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

The present invention is also directed to a hole transport material to be used for a layer having the function of transporting holes in an organic EL device, wherein the hole transport material is characterized in that when the hole transport material is dissolved or dispersed in a liquid so that the concentration thereof becomes 2.0 wt% , the liquid contains one or more cationic impurities, but an amount of the cationic impurity of which content is the largest among the cationic impurities is 10 ppm or less.

According to the invention described above, it is also possible to provide a hole transport material by which the decrease of light-emission luminance of an organic EL device can be suppressed.

Further, it is preferred that the cationic impurities include metal ions. By removing the metal ions, it possible to provide a hole transport material that can more reliably suppress the decrease of light-emission luminance of an organic EL device.

Further, in the above mentioned hole transport material, it is preferred that the volume resistivity of the hole transport material is 10 Ω·cm or larger. This makes it possible to provide an organic EL element having higher light emitting efficiency.

Further, it is also preferred that the hole transport material contains a low-molecular hole transport material. By containing such a low-molecular hole transport material, it is possible to obtain a dense hole transport layer so that hole transport ability is improved.

Furthermore, the hole transport material may contain a high-molecular hole transport material. By containing such a high-molecular hole transport material, the hole transport material can be dissolved in a solvent with relatively ease, so that a hole transport layer can be easily formed by means of various application methods such an ink-jet printing method.

Moreover, it is also preferred that the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds. These compounds are preferably since they have high hole transport ability.

Another aspect of the present invention is directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium; and
eliminating sulfate ions contained in the liquid by means of eliminating means which separates or eliminates the sulfate ions, and then removing the solvent or dispersion medium from the liquid, thereby refining the hole transport material,
wherein thus refined hole transport material is characterized in that when the layer having the function of transporting holes is formed using the hole transport material, an amount of sulfate ions contained in the layer is 1000 ppm or less.

This invention is also directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium; and
eliminating one or more kinds of anionic impurities other than sulfate ions contained in the liquid by means of eliminating means which separates or eliminates the anionic impurities, and then removing the solvent or dispersion medium from the liquid, thereby refining the hole transport material,
wherein thus refined hole transport material is characterized in that when the layer is formed using the hole transport material, an amount of the anionic impurity of which content is the largest among the anionic impurities contained in the layer is 100 ppm or less.

This invention is also directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium; and
eliminating one or more kinds of cationic impurities contained in the liquid by means of eliminating means which separates or eliminates the cationic impurities, and then removing the solvent or dispersion medium from the liquid, thereby refining the hole transport material,
wherein thus refined hole transport material is characterized in that when the layer is formed using the hole transport material, an amount of the cationic impurity of which content is the largest among the cationic impurities contained in the layer is 500 ppm or less.

This invention is also directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium;
eliminating sulfate ions contained in the liquid by means of eliminating means which separates or eliminates the sulfate ions, and then removing the solvent or dispersion medium from the liquid, thereby refining the hole transport material,
wherein thus refined hole transport material is characterized in that when the hole transport material is dissolved or dispersed in a liquid so that the concentration thereof becomes 2.0 wt%, an amount of sulfate ions contained in the liquid is 20 ppm or less.

This invention is also directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium;
eliminating one or more kinds of anionic impurities other than sulfate ions contained in the liquid by means of eliminating means which separates or eliminates the anionic impurities, and then removing the solvent or dispersion medium from the liquid, thereby refining the hole transport material,
wherein thus refined transport material is characterized in that when the hole transport material is dissolved or dispersed in a liquid so that the concentration thereof becomes 2.0 wt% , an amount of the anionic impurity of which content is the largest among the anionic impurities contained in the liquid is 2 ppm or less.

This invention is also directed to a method of manufacturing a hole transport material to be used for a layer having the function of transporting holes in an organic EL device, in which the method comprises the steps of:
preparing a liquid in which a hole transport material is dissolved or dispersed in a solvent or a dispersion medium;
eliminating one or more kinds of cationic impurities contained in the liquid by means of eliminating means which separates or eliminates the cationic impurities, and then removing the solvent or dispersion medium from the liquid, thereby refining the hole transport material,
wherein thus refined transport material is characterized in that when the hole transport material is dissolved or dispersed in a liquid so that the concentration thereof becomes 2.0 wt%, an amount of the cationic impurity of which content is the largest among the cationic impurities contained in the liquid is 10 ppm or less.

According to the manufacturing methods of the present invention described above, it is possible to eliminate anionic impurities and/or cationic impurities from a hole transport material with relatively ease and in a relatively short period of time. Further, according to the invention, only by appropriately selecting the kind of eliminating means to be used, it is possible to eliminate target anionic impurities and/or cationic impurities reliably and efficiently.

These and other objects, structures and advantages of the present invention will be apparent from the following detailed description of the invention and the examples thereof which proceeds with reference to the accompanying drawing.

### BRIEF DESCRIPTION OF THE DRAWING

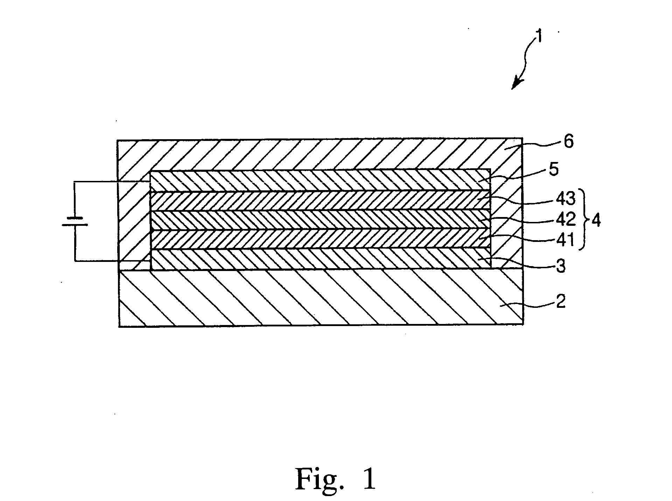

Fig. 1 is a cross-sectional view which shows an example of an organic EL device.

### DETAILED DESCRIPTION OF THE INVENTION

First, before discussing the details of the hole transport material and the method of manufacturing such a hole transport material of the present invention, an example of an organic EL device (organic electroluminescent device) which has a hole transport layer formed using the hole transport material of the present invention will be described.

### <Organic EL device>

Fig. 1 is a cross-sectional view which shows an example of an organic EL device.

An organic EL device 1 shown in Fig. 1 includes a transparent substrate 2, an anode 3 provided on the substrate 2, an organic EL layer 4 provided on the anode 3, a cathode 5 provided on the organic EL layer 4 and a protection layer 6 provided so as to cover these layers 3, 4 and 5.

The substrate 2 serves as a support of the organic EL device 1, and the layers described above are formed on this substrate 2.

As a constituent material of the substrate 2, a material having a light transmitting property and a good optical property can be used. Examples of such a material include various resin materials such as polyethylene terephthalate, polyethylene naphthalate, polypropylene, cycloolefin polymer, polyamide, polyether sulfone, polymethyl methacrylate, polycarbonate, and polyarylate, various glass materials, and the like. These materials can be used singly or in combination of two or more of them.

The thickness of the substrate 2 is not limited to any specific value, but is preferably in the range of about 0.1 to 30 mm, more preferably in the range of about 0.1 to 10 mm.

The anode 3 is an electrode which injects holes into the organic EL layer 4 (that is, into a hole transport layer 41 described later). Further, this anode 3 is made substantially transparent (which includes colorless and transparent, colored and transparent, or translucent) so that light emission from the organic EL layer 4 (that is, into a light emitting layer 42 described later) can be visually identified.

From such a viewpoint, a material having a high work function, excellent conductivity and a light transmitting property is preferably used as a constituent material of the anode 3 (hereinafter, referred to as "anode material").

Examples of such an anode material include oxides such as ITO (Indium Tin Oxide), SnO₂, Sb-containing SnO₂ and Al-containing ZnO, Au, Pt, Ag, Cu, and alloys containing two or more of them. These materials can be used singly or in combination of two or more of them.

The thickness of the anode 3 is not limited to any specific value, but is preferably in the range of about 10 to 200 nm, more preferably in the range of about 50 to 150 nm. If the thickness of the anode 3 is too thin, there is a fear that a function as the anode 3 is not sufficiently exhibited. On the other hand, if the anode 3 is too thick, there is a fear that light transmittance is significantly lowered depending on the kind of anode material used, or the like, thus resulting in an organic EL device that can not be suitably used for practical use.

It is to be noted that conductive resins such as polythiophene, polypyrrole, and the like can also be used for the anode material, for example.

On the other hand, the cathode 5 is an electrode which injects electrons into the organic EL layer 4 (that is, into an electron transport layer 43 described later).

As a constituent material of the cathode 5 (hereinafter, referred to as "cathode material"), a material having a low work function is preferably used.

Examples of such a cathode material include Li, Mg, Ca, Sr, La, Ce, Er, Eu, Sc, Y, Yb, Ag, Cu, Al, Cs, Rb, and alloys containing two or more of them. These materials can be used singly or in combination of two or more of them.

Particularly, in a case where an alloy is used as the cathode material, an alloy containing a stable metallic element such as Ag, Al, or Cu, specifically an alloy such as MgAg, AlLi, or CuLi is preferably used. The use of such an alloy as the cathode material makes it possible to improve the electron injection efficiency and stability of the cathode 5.

The thickness of the cathode 5 is preferably in the range of about 1 nm to 1 µm, more preferably in the range of about 100 to 400 nm. If the thickness of the cathode 5 is too thin, there is a fear that a function as the cathode 5 is not sufficiently exhibited. On the other hand, if the cathode 5 is too thick, there is a fear that the light emitting efficiency of the organic EL device 1 is lowered.

Between the anode 3 and the cathode 5, there is provided the organic EL layer 4. The organic EL layer 4 includes the hole transport layer 41, the light emitting layer 42, and the electron transport layer 43. These layers 41, 42 and 43 are formed on the anode 3 in this order.

The hole transport layer 41 has the function of transporting holes, which are injected from the anode 3, to the light emitting layer 42.

Any material can be employed as a constituent material of the hole transport layer 41 (hereinafter, referred to as "hole transport material") so long as it has a hole transport ability. However, it is preferred that the constituent material of the hole transport layer 41 is formed of a compound having a conjugated system. This is because a compound having a conjugated system can extremely smoothly transport holes due to a property resulting from its unique spread of an electron cloud, so that such a compound has an especially excellent hole transport ability.

Further, the hole transport material to be used may be in either of the solid form, semisolid form or liquid form at room temperature. Since such a hole transport material in either of the above-mentioned forms is easy to handle, a hole transport layer 41 can be easily and reliably formed, thus it is possible to obtain a higher performance organic EL device 1.

Examples of such a hole transport material include: arylcycloalkane-based compounds such as 1,1-bis(4-di-para-triaminophenyl)cyclohexane and 1,1'-bis(4-di-para-tolylaminophenyl)-4-phenyl-cyclohexane; arylamine-based compounds such as 4,4',4'' -trimethyltriphenylamine, N,N,N',N'-tetraphenyl-1,1'-biphenyl-4,4'-diamine, N,N'-diphenyl-N,N'-bis(3-methylphenyl)-1,1'-biphenyl-4,4'-diami ne(TPD1), N,N'-diphenyl-N,N'-bis(4-methoxyphenyl)-1,1'-biphenyl-4,4'-diam ine(TPD2), N,N,N',N'-tetrakis(4-methoxyphenyl)-1,1'-biphenyl-4,4'-diamine( TPD3), N,N'-di(1-naphthyl)-N,N'-diphenyl-1,1'-biphenyl-4,4'-diamine(α-NPD), and TPTE; phenylenediamine-based compounds such as N,N,N',N'-tetraphenyl-para-phenylenediamine, N,N,N',N'-tetra(para-tolyl)-para-phenylenediamine, and N,N,N',N'-tetra(meta-tolyl)-meta-phenylenediamine(PDA); carbazole-based compounds such as carbazole, N-isopropylcarbazole, and N-phenylcarbazole; stilbene-based compounds such as stilbene, and 4-di-para-tolylaminostilbene; oxazole-based compounds such as OₓZ; triphenylmethane-based compounds such as triphenylmethane, and m-MTDATA; pyrazoline-based compounds such as 1-phenyl-3-(para-dimethylaminophenyl)pyrazoline; benzine(cyclohexadiene)-based compounds; triazole-based compounds such as triazole; imidazole-based compounds such as imidazole; oxadiazole-based compounds such as 1,3,4-oxadiazole, and 2,5-di(4-dimethylaminophenyl)-1,3,4-oxadiazole; anthracene-based compounds such as anthracene, and 9-(4-diethylaminostyryl)anthracene; fluorenone-based compounds such as fluorenone, 2,4,7-trinitro-9-fluorenone, and 2,7-bis(2-hydroxy-3-(2-chlorophenylcarbamoyl)-1-naphthylazo)flu orenone; aniline-based compounds such as polyaniline; silane-based compounds; thiophene-based compounds such as polythiophene, and poly(thiophenevinylene); pyrrole-based compounds such as poly(2,2'-thienylpyrrole), and 1,4-dithioketo-3,6-diphenyl-pyrrolo-(3,4-c)pyrrolopyrrole; florene-based compounds such as florene; porphyrin-based compounds such as porphyrin, and metal tetraphenylporphyrin; quinacridon-based compounds such as quinacridon; metallic or non-metallic phthalocyanine-based compounds such as phthalocyanine, copper phthalocyanine, tetra(t-butyl)copper phthalocyanine, and iron phthalocyanine; metallic or non-metallic naphthalocyanine-based compounds such as copper naphthalocyanine, vanadyl naphthalocyanine, and monochloro gallium naphthalocyanine; and benzidine-based compounds such as N,N'-di(naphthalene-1-yl)-N,N'-diphenyl-benzidine and N,N,N',N'-tetraphenylbenzidine. These compounds can be used singly or in combination of two or more. All of them have a high hole transport ability.

These compounds can be used as a monomer or an oligomer (which is a low-molecular hole transport material), or as a prepolymer or a polymer containing these compounds in a main chain or a side chain thereof (which is a high-molecular hole transport material).

A high-molecular hole transport material such as poly(thiophene/styrenesulfonic acid)-based compounds, e.g., poly(3,4-ethylenedioxythiophene/styrenesulfonic acid) (PEDOT/PSS) can also be used for the hole transport material. This high-molecular hole transport material also has a high hole transport ability. On the other hand, however, this high-molecular hole transport material contains a relatively larger amount of sulfate ions due to the polystyrenesulfonic acid content as compared with other hole transport materials. Therefore, it is particularly effective to eliminate sulfate ions therefrom.

Further, the above mentioned compounds that can be used as a hole transport material may be used singly or in combination of two or more of them.

In this regard, it is to be noted that the use of the low-molecular hole transport material makes it possible to obtain a dense hole transport layer 41, thereby improving the hole transport ability thereof. On the other hand, the use of the high-molecular hole transport material makes it possible to relatively easily dissolve it in a solvent, thus enabling the hole transport layer 41 to be formed easily by means of various application methods such as an ink-jet printing method and the like. Further, by using such low-molecular hole transport material and high-molecular hole transport material together, it is possible to obtain the synergistic effect resulted from the effect of the low-molecular hole transport material and the effect of the high-molecular hole transport material. That is, it is possible to obtain an effect that a dense hole transport layer 41 having an excellent hole transport ability can be easily formed by means of various application methods such as an ink-jet printing method and the like.

The thickness of the hole transport layer 41 is not limited to any specific value, but is preferably in the range of about 10 to 150 nm, more preferably in the range of about 50 to 100 nm. If the thickness of the hole transport layer 41 is too thin, there is a fear that a pin hole is produced. On the other hand, if the thickness of the hole transport layer 41 is too thick, there is a fear that the transmittance of the hole transport layer 41 is lowered so that the chromaticity (hue) of luminescent color of the organic EL device 1 is changed.

The hole transport material of the present invention is particularly suitable for forming such a relatively thin hole transport layer 41.

The electron transport layer 43 has the function of transporting electrons, which are injected from the cathode 5, to the light emitting layer 42.

Examples of a constituent material of the electron transport layer 43 (an electron transport material) include: benzene-based compounds (starburst-based compounds) such as 1,3,5-tris[(3-phenyl-6-tri-fluoromethyl)quinoxaline-2-yl] benzene (TPQ1), and 1,3,5-tris[{3-(4-t-butylphenyl)-6-trisfluoromethyl}quinoxaline-2-yl]benzene (TPQ2); naphthalene-based compounds such as naphthalene; phenanthrene-based compounds such as phenanthrene; chrysene-based compounds such as chrysene; perylene-based compounds such as perylene; anthracene-based compounds such as anthracene; pyrene-based compounds such as pyrene; acridine-based compounds such as acridine; stilbene-based compounds such as stilbene; thiophene-based compounds such as BBOT; butadiene-based compounds such as butadiene; coumarin-based compounds such as coumarin; quinoline-based compounds such as quinoline; bistyryl-based compounds such as bistyryl; pyrazine-based compounds such as pyrazine and distyrylpyrazine; quinoxaline-based compounds such as quinoxaline; benzoquinone-based compounds such as benzoquinone, and 2,5-diphenyl-para-benzoquinone; naphthoquinone-based compounds such as naphthoquinone; anthraquinone-based compounds such as anthraquinone; oxadiazole-based compounds such as oxadiazole, 2-(4-biphenylyl)-5-(4-t-butylphenyl)-1,3,4-oxadiazole (PBD), BMD, BND, BDD, and BAPD; triazole-based compounds such as triazole, and 3,4,5-triphenyl-1,2,4-triazole; oxazole-based compounds; anthrone-based compounds such as anthrone; fluorenone-based compounds such as fluorenone, and 1,3,8-trinitro-fluorenone (TNF); diphenoquinone-based compounds such as diphenoquinone, and MBDQ; stilbenequinone-based compounds such as stilbenequinone, and MBSQ; anthraquinodijmethane-based compounds; thiopyran dioxide-based compounds; fluorenylidenemethane-based compounds; diphenyldicyanoethylene-based compounds; florene-based compounds such as florene; metallic or non-metallic phthalocyanine-based compounds such as phthalocyanine, copper phthalocyanine, and iron phthalocyanine; and various metal complexes such as 8-hydroxyquinoline aluminum (Alq₃), and complexes having benzooxazole or benzothiazole as a ligand.

Further, the above mentioned compounds that can be used as an electron transport material may be used singly or in combination. of two or more of them.

The thickness of the electron transport layer 43 is not limited to any specific value, but is preferably in the range of about 1 to 100 nm, more preferably in the range of about 20 to 50 nm. If the thickness of the electron transport layer 43 is too thin, there is a fear that a pin hole is produced, causing a short-circuit. On the other hand, if the electron transport layer 43 is too thick, there is a fear that the value of resistance becomes high.

When a current flows between the anode 3 and the cathode 5 (that is, a voltage is applied across the anode 3 and the cathode 5), holes are moved in the hole transport layer 41 and electrons are moved in the electron transport layer 43, and the holes and the electrons are then recombined in the light emitting layer 42. Then, in the light emitting layer 42, excitons are produced by energy released upon the recombination, and the excitons release energy (in the form of fluorescence or phosphorescence) or emit light when returning to the ground state.

Any material can be used as a constituent material of the light emitting layer 42 (a light emitting material) so long as it can provide a field where holes can be injected from the anode 3 and electrons can be injected from the cathode 5 during the application of a voltage to allow the holes and the electrons to be recombined.

Such light emitting materials include various low-molecular light emitting materials and various high-molecular light emitting materials (which will be mentioned below). These materials can be used singly or in combination of two or more of them.

In this regard, it is to be noted that the use of a low-molecular light emitting material makes it possible to obtain a dense light emitting layer 42, thereby improving the light emitting efficiency of the light emitting layer 42. Further, since such a high-molecular light emitting material is relatively easily dissolve in a solvent, it is possible to form the light emitting layer 42 easily by means of various application methods such as an ink-jet printing method and the like. Furthermore, if the low-molecular light emitting material and the high-molecular light emitting material are used together, it is possible to obtain the synergistic effect resulted from the effect of the low-molecular light emitting material and the effect of the high-molecular light emitting material. That is, it is possible to obtain an effect that a dense light emitting layer 42 having an excellent light emitting efficiency can be easily formed by means of various application methods such as an ink-jet printing method and the like.

Examples of such a low-molecular light emitting material include: benzene-based compounds such as distyrylbenzene (DSB), and diaminodistyrylbenzene (DADSB); naphthalene-based compounds such as naphthalene and Nile red; phenanthrene-based compounds such as phenanthrene; chrysene-based compounds such as chrysene and 6-nitrochrysene; perylene-based compounds such as perylene, and N,N'-bis(2,5-di-t-butylphenyl)-3,4,9,10-perylene-di-carboxyimid e (BPPC); coronene-based compounds such as coronene; anthracene-based compounds such as anthracene, and bisstyrylanthracene; pyrene-based compounds such as pyrene; pyran-based compounds such as 4-(di-cyanomethylene)-2-methyl-6-(para-dimethylaminostyryl)-4H-pyran (DCM); acridine-based compounds such as acridine; stilbene-based compounds such as stilbene; thiophene-based compounds such as 2,5-dibenzooxazolethiophene; benzooxazole-based compounds such as benzooxazole; benzoimidazole-based compounds such as benzoimidazole; benzothiazole-based compounds such as 2,2'-(para-phenylenedivinylene)-bisbenzothiazole; butadiene-based compounds such as bistyryl(1,4-diphenyl-1,3-butadiene), and tetraphenylbutadiene; naphthalimide-based compounds such as naphthalimide; coumarin-based compounds such as coumarin; perynone-based compounds such as perynone; oxadiazole-based compounds such as oxadiazole; aldazine-based compounds; cyclopentadiene-based compounds such as 1,2,3,4,5-pentaphenyl-1,3-cyclopentadiene (PPCP); quinacridone-based compounds such as quinacridone and quinacridone red; pyridine-based compounds such as pyrrolopyridine, and thiadiazolopyridine; spiro compounds such as 2,2',7,7'-tetraphenyl-9,9'-spirobifluorene; metallic or non-metallic phthalocyanine-based compounds such as phthalocyanine (H₂Pc), and copper phthalocyanine; florene-based compounds such as florene; and various metallic complexes such as 8-hydroxyquinoline aluminum (Alq₃), tris(4-methyl-8-quinolinolate) aluminum(III) (Almq₃), 8-hydroxyquinoline zinc (Znq₂), (1,10-phenanthroline)-tris-(4,4,4-trifluoro-1-(2-thienyl)-butan e-1,3-dionate) europium(III) (Eu(TTA)₃(phen)), fac-tris(2-phenylpyridine) iridium (Ir(ppy)₃), and 2,3,7,8,12,13,17,18-octaethyl-21H, 23H-porphin platinum(II).

Examples of a high-molecular light emitting material include polyacetylene-based compounds such as trans-type polyacetylene, cis-type polyacetylene, poly(di-phenylacetylene) (PDPA), and poly(alkyl, phenylacetylene) (PAPA); polyparaphenylenevinylene-based compounds such as poly(para-phenylenevinylene) (PPV), poly(2,5-dialkoxy-para-phenylenevinylene) (RO-PPV), cyano-substituted-poly(para-phenylenevinylene) (CN-PPV), poly(2-dimethyloctylsilyl-para-phenylenevinylene) (DMOS-PPV), and poly(2-methoxy-5-(2'-ethylhexoxy)-para-phenylenevinylene) (MEH-PPV); polythiophene-based compounds such as poly(3-alkylthiophene) (PAT), and poly(oxypropylene)triol (POPT); polyfluorene-based compounds such as poly(9,9-dialkylfluorene) (PDAF), α,ω-bis[N,N'-di(methylphenyl)aminophenyl]-poly[9,9-bis(2-ethylhexyl)fluorene-2,7-diyl] (PF2/6am4), poly(9,9-dioctyl-2,7-divinylenefluorenyl)-alt-co(anthracene-9,1 0-diyl); polyparaphenylene-based compounds such as poly(para-phenylene) (PPP), and poly(1,5-dialkoxy-para-phenylene) (RO-PPP); polycarbazole-based compounds such as poly(N-vinylcarbazole) (PVK); and polysilane-based compounds such as poly(methylphenylsilane) (PMPS), poly(naphthylphenylsilane) (PNPS), and poly(biphenylylphenylsilane) (PBPS).

The thickness of the light emitting layer 42 is not limited to any specific value, but is preferably in the range of about 10 to 150 nm, more preferably in the range of about 50 to 100 nm. By setting the thickness of the light emitting layer to a value within the above range, recombination of holes and electrons efficiently occurs, thereby enabling the light emitting efficiency of the light emitting layer 42 to be further improved.

Although, in the present embodiment, each of the light emitting layer 42, the hole transport layer 41 and the electron transport layer 43 is separately provided, they may be formed into a hole-transportable light emitting layer which combines the hole transport layer 41 with the light emitting layer 42 or an electron-transportable light emitting layer which combines the electron transport layer 43 with the light emitting layer 42. In this case, an area in the vicinity of the interface between the hole-transportable light emitting layer and the electron transport layer 43 or an area in the vicinity of the interface between the electron-transportable light emitting layer and the hole transport layer 41 functions as the light emitting layer 42.

Further, in a case where the hole-transportable light emitting layer is used, holes injected from an anode into the hole-transportable light emitting layer are trapped by the electron transport layer, and in a case where the electron-transportable light emitting layer is used, electrons injected from a cathode into the electron-transportable light emitting layer are trapped in the electron-transportable light emitting layer. In both cases, there is an advantage that the recombination efficiency of holes and electrons can be improved.

Furthermore, between the adjacent layers in the layers 3,4 and 5, any additional layer may be provided according to its purpose. For example, a hole injecting layer may be provided between the hole transport layer 41 and the anode 3, or an electron injecting layer may be provided between the electron transport layer 43 and the cathode 5. In such a case where the organic EL device 1 is provided with the hole injecting layer, the hole transport material of the present invention may be employed for the hole injecting layer. On the other hand, in a case where the organic EL device 1 is provided with the electron injecting layer, not only the electron transport material mentioned above but also alkali halide such as LiF, and the like may be employed for the electron injecting layer.

The protection layer 6 is provided so as to cover the layers 3, 4 and 5 constituting the organic EL device 1. This protection layer 6 has the function of hermetically sealing the layers 3, 4 and 5 constituting the organic EL device 1 to shut off oxygen and moisture. By providing such a protection layer 6, it is possible to obtain the effect of improving the reliability of the organic EL device 1 and the effect of preventing the alteration and deterioration of the organic EL device 1.

Examples of a constituent material of the protection layer 6 include Al, Au, Cr, Nb, Ta and Ti, alloys containing them, silicon oxide, various resin materials, and the like. In this regard, it is to be noted that in a case where a conductive material is used as a constituent material of the protection layer 6, it is preferred that an insulating film is provided between the protection layer 6 and each of the layers 3, 4 and 5 to prevent a short circuit therebetween, if necessary.

This organic EL device 1 can be used for a display, for example, but it can also be used for various optical purposes such as a light source and the like.

In a case where the organic EL device 1 is applied to a display, the drive system thereof is not particularly limited, and either of an active matrix system or a passive matrix system may be employed.

The organic EL device 1 as described above can be manufactured in the following manner, for example.

<1> First, the substrate 2 is prepared, and the anode 3 is then formed on the substrate 2.

The anode 3 can be formed by, for example, chemical vapor deposition (CVD) such as plasma CVD, thermal CVD, or laser CVD, dry plating such as vacuum deposition, sputtering, or ion plating, wet plating such as electrolytic plating, immersion plating, or electroless plating, sputtering, a sol-gel method, a MOD method, bonding of a metallic foil, or the like.

<2> Next, the hole transport layer 41 is formed on the anode 3.

The hole transport layer 41 can be formed by, for example, applying a hole transport layer material (material for forming a hole transport layer), obtained by dissolving the hole transport material as mentioned above in a solvent or dispersing it in a dispersion medium, on the anode 3.

In the application of the hole transport layer material, various application methods such as a spin coating method, a casting method, a micro gravure coating method, a gravure coating method, a bar coating method, a roll coating method, a wire-bar coating method, a dip coating method, a spray coating method, a screen printing method, a flexographic printing method, an offset printing method, an ink-jet printing method, and the like can be employed. According to such an application method, it is possible to relatively easily form the hole transport layer 41.

Examples of a solvent in which the hole transport material is to be dissolved or a dispersion medium in which the hole transport material is to be dispersed include: inorganic solvents such as nitric acid, sulfuric acid, ammonia, hydrogen peroxide, water, carbon disulfide, carbon tetrachloride, and ethylene carbonate; and various organic solvents such as ketone-based solvents e.g., methyl ethyl ketone (MEK), acetone, diethyl ketone, methyl isobutyl ketone (MIBK), methyl isopropyl ketone (MIPK), and cyclohexanone, alcohol-based solvents e.g., methanol, ethanol, isopropanol, ethylene glycol, diethylene glycol (DEG), and glycerol, ether-based solvents e.g., diethyl ether, diisopropyl ether, 1,2-dimethoxy ethane (DME), 1,4-dioxane, tetrahydrofuran (THF), tetrahydropyran (THP), anisole, diethylene glycol dimethyl ether (diglyme), and diethylene glycol ethyl ether (Carbitol), cellosolve-based solvents e.g., methyl cellosolve, ethyl cellosolve, and phenyl cellosolve, aliphatic hydrocarbon-based solvents e.g, hexane, pentane, heptane, and cyclohexane, aromatic hydrocarbon-based solvents e.g., toluene, xylene, and benzene, aromatic heterocyclic compound-based solvents e.g., pyridine, pyrazine, furan, pyrrole, thiophene, and methyl pyrrolidone, amide-based solvents e.g., N,N-dimethylformamide (DMF), and N,N-dimethylacetamide (DMA), halogen compound-based solvents e.g., dichloromethane, chloroform, and 1,2-dichloroethane, ester-based solvents e.g., ethyl acetate, methyl acetate and ethyl formate, sulfur compound-based solvents e.g., dimethyl sulfoxide (DMSO) and sulfolane, nitrile-based solvents e.g., acetonitrile, propionitrile, and acrylonitrile, organic acid-based solvents e.g., formic acid, acetic acid, trichloroacetic acid, and trifluoroacetic acid, and mixed solvents containing them.

If necessary, an obtained coating may be subjected to heat treatment, for example, in the atmosphere or an inert atmosphere or under a reduced pressure (or a vacuum). This makes it possible to dry the coating (removal of a solvent or a dispersion medium) or polymerize the hole transport material, for example. In this regard, it is to be noted that the coating may be dried without heat treatment.

Further, in a case where a low-molecular hole transport material is used, a binder (high-molecular binder) may be added to the hole transport layer material, if necessary.

As a binder, one which does not extremely inhibit charge transport and has a low absorptivity for visible radiation is preferably used. Specifically, examples of such a binder include polyethylene oxide, polyvinylidene fluoride, polycarbonate, polyacrylate, polymethyl acrylate, polymethyl methacrylate, polystyrene, polyvinyl chloride, polysiloxane, and the like, and they can be used singly or in combination of two or more of them. Alternatively, the high-molecular hole transport material as mentioned above may be used for the binder.

It is to be noted that in a case where a low-molecular hole transport material is used, the hole transport layer 41 may also be formed by, for example, vacuum deposition or the like.

<3> Next, the light emitting layer 42 is formed on the hole transport layer 41.

The light emitting layer 42 can be formed in the same manner as the hole transport layer 41. Namely, the light emitting layer 42 can be formed using the light emitting material mentioned above in a manner as described above with reference to the hole transport layer 41.

<4> Next, the electron transport layer 43 is formed on the light emitting layer 42.

The electron transport layer 43 can be formed in the same manner as the hole transport layer 41. Namely, the electron transport layer 43 can be formed using the electron transport material mentioned above in a manner as described above with reference to the hole transport layer 41.

<5> Next, the cathode 5 is formed on the electron transport layer 43.

The cathode 5 can be formed by, for example, vacuum deposition, sputtering, bonding of a metallic foil, or the like.

<6> Next, the protection layer 6 is formed so as to cover the anode 3, the organic EL layer 4 and the cathode 5.

The protection layer 6 can be formed (provided) by, for example, bonding a box-like protection cover constituted of the material as mentioned above by the use of various curable resins (adhesives).

As for the curable resins, all of thermosetting resins, photocurable resins, reactive curable resins, and anaerobic curable resins can be used.

The organic EL device 1 is manufactured through these processes as described above.

Next, the hole transport material and the method of manufacturing the hole transport material according to the present invention will be described.

### <Hole transport material)

The hole transport material of the present invention is used for the hole transport layer 41 (that is, a layer having the function of transporting holes) in the organic EL device 1 as described above.

In order to suppress the decrease of light-emission luminance of the organic EL device 1, the present inventors have been made extensive researches and studies for constituent materials of all the layers constituting the organic EL device 1, and in particular they have paid their attentions to a hole transport material among the constituent materials. As a result, the present inventors have found that the decrease of light-emission luminance of the organic EL device 1 can be effectively suppressed by controlling the amount of impurities contained in the hole transport material, especially the amount of anionic impurities or cationic impurities, to within a predetermined amount, leading to the completion of the present invention.

Specifically, the present invention is required to satisfy at least one of the following conditions (A) and (B).
(A) When the hole transport layer 41 (that is, a layer having the function of transporting holes) is formed using the hole transport material of the present invention, the amount of anionic impurities or cationic impurities contained in the hole transport layer 41 should lie within the range described below.
(B) When the hole transport material of the present invention is dissolved or dispersed in a liquid so that the concentration thereof becomes 2.0 wt%, the amount of anionic impurities or cationic impurities contained in the liquid should lie within the range described below. Hereinafter, each of the conditions (A) and (B) will be described.

<A: Amount of impurities contained in hole transport layer>
A-I: The amount of sulfate ions contained in the hole transport layer is preferably 1,000 ppm or less, more preferably 750 ppm or less, even more preferably 500 ppm or less.
A-II: In the case where one or more kinds of anionic impurities (other than sulfate ions) are contained in the hold transport layer, the amount of the anionic impurity of which content is the largest among the anionic impurities is preferably 100 ppm or less, more preferably 75 ppm or less, even more preferably 50 ppm or less.
A-III: In the case where one or more kinds of cationic impurities are contained in the hole transport layer, the amount of the cationic impurity of which content is the largest among the cationic impurities is preferably 500 ppm or less, more preferably 250 ppm or less, even more preferably 50 ppm or less.

In this connection, it is preferred that one of these conditions A-I to A-III is satisfied, more preferably any two of them are satisfied, and even more preferably all the three are satisfied.

If the amount of impurities contained in the hole transport layer 41 is large, a reaction between the hole transport material and the impurities is likely to occur. This reaction causes the deterioration of the hole transport material, which becomes a factor that decreases the light-emission luminance of the organic EL device 1.

On the other hand, if a hole transport material in which the amount of impurities contained therein is controlled to within the above mentioned range, it is possible to eliminate the disadvantage described above, thereby enabling the decrease of light-emission luminance of the organic EL device 1 to be suppressed. As a result, it is possible to provide an organic EL device 1 that can maintain excellent light emitting properties for a long period of time.

Further, in a case where the hole transport material contains plural kinds of anionic impurities or cationic impurities, the total amount of the anionic impurities contained in the hole transport layer 41 is preferably 500 ppm or less, more preferably 225 ppm or less, and the total amount of the cationic impurities contained in the hole transport layer 41 is preferably 1,500 ppm or less, more preferably 500 ppm or less. By setting the total amount of the anionic impurities or cationic impurities contained in the hole transport material to within the above range, it is possible to more reliably suppress the decrease of light-emission luminance of the organic EL device 1.
<B: Amount of impurities contained in 2.0 wt% liquid of hole transport material (hereinafter simply referred to as a "2.0 wt% liquid")>
B-I: The amount of sulfate ions contained in the 2.0 wt% liquid is preferably 20 ppm or less, more preferably 15 ppm or less, even more preferably 10 ppm or less.
B-II: In the case where one or more kinds of anionic impurities (other than sulfate ion) are contained in the liquid, the amount of the anionic impurity of which content is the largest among the anionic impurities is preferably 2 ppm or less, more preferably 1.5 ppm or less, even more preferably 1 ppm or less.
B-III: In the case where one or more kinds of cationic impurities are contained in the liquid, the amount of the cationic impurity of which content is the largest among the cationic impurities is preferably 10 ppm or less, more preferably 5 ppm or less, even more preferably 1 ppm or less.

In this connection, it is preferred that one of these conditions B-I to B-III is satisfied, more preferably any two of them are satisfied, even more preferably all the three are satisfied. As described above, this also makes it possible to suppress the decrease of light-emission luminance of the organic EL device 1, and as a result, the organic EL device 1 can maintain excellent light emitting properties for a long period of time.

Further, in a case where the hole transport material contains plural kinds of anionic impurities or cationic impurities, the total amount of the anionic impurities contained in the 2.0 wt% liquid thereof is preferably 10 ppm or less, more preferably 4.5 ppm or less, and the total amount of the cationic impurities contained in the 2.0 wt% liquid is preferably 30 ppm or less, more preferably 10 ppm or less. By reducing the total amount of the anionic impurities or cationic impurities contained in the hole transport material to a value less than the above lower limit value, it is possible to more reliably suppress the decrease of light-emission luminance of the organic EL device 1.

As for anionic impurities to be eliminated (other than sulfate ion), various anionic impurities can be mentioned. In particular, it is preferred that at least one of HCO₂⁻ (formate ion), C₂O₄²⁻ (oxalate ion), and CH₃CO₂⁻ (acetate ion) is eliminated. All of these ions have extremely high reactivity with the hole transport material, so that they are particularly apt to deteriorate the hole transport material. Therefore, the elimination of such ions makes it possible to obtain a hole transport material which can more reliably suppress the decrease of light-emission luminance of the organic EL device 1.

Further, as for cationic impurities to be eliminated, various cationic impurities can also be mentioned. In particular, it is preferred that metal ions are eliminated. Since metal ions also have extremely high reactivity with the hole transport material, they are also apt to deteriorate the hole transport material. Therefore, the elimination of metal ions makes it possible to obtain a hole transport material which can more reliably suppress the decrease of light-emission luminance of the organic EL device 1.

As for such metal ions, ions of various metals can be mentioned. In particular, it is preferred that ions of at least one of metals belonging to group Ia, group IIa, group VIa, group VIIa, group VIII, and group IIb of the periodic table are eliminated. By eliminating these metal ions, the effect of suppressing the decrease of light-emission luminance of the organic EL device 1 is especially and conspicuously exhibited.

### <Method of refining hole transport material>

As for a method for eliminating anionic impurities (including sulfate ions) and cationic impurities (hereinafter, referred to as "ionic impurities") from the hole transport material, the following methods can be employed for a low-molecular hole transport material and a high-molecular hole transport material, respectively, for example.

Specifically, in the case of a low-molecular hole transport material, examples of such an elimination method include an electrolytic separation method, a neutralization method, a sublimation refining method, a recrystallization method, a reprecipitation method, and a method using elimination means capable of separating or eliminating anionic impurities and/or cationic impurities. These methods can be used singly or in combination of two or more of them.

Here, examples of the elimination means include a filter, a column filler, a permeable membrane (dialyzer), and a medium with a density gradient. Specifically, examples of the elimination method using the elimination means include: a filtration method; various chromatography methods such as an adsorption chromatography method, an ion exchange chromatography method, a partition (normal phase or reverse phase) chromatography method, a molecular sieve chromatography method (gel filtration), a countercurrent distribution chromatography method, and a droplet countercurrent distribution chromatography method; a centrifugal separation method such as density gradient centrifugation; an ultrafiltration method; and a dialysis method.

On the other hand, in the case of a high-molecular hole transport material, an elimination method using elimination means, such as a filtration method, an ultrafiltration method, or a dialysis method is suitably employed.

Among these methods, as a method for eliminating ionic impurities, an elimination method using elimination means (that is, a method of refining a hole transport material which is employed in the present invention) is preferably employed, and in particular, a filtration method is preferably employed. According to such a method, it is possible to relatively and easily eliminate ionic impurities from the hole transport material in a short period of time. Further, by only selecting the kind of filter (elimination means) to be used appropriately, target ionic impurities can be efficiently and reliably eliminated.

Hereinafter, a detailed description will be made with regard to the method for eliminating ionic impurities based on the typical case where the filtration method is employed.

According to the filtration method, a solution for refinement or a dispersion liquid for refinement obtained by dissolving a hole transport material in a solvent or dispersing a hole transport material in a dispersion medium (hereinafter, they are referred to as "solution for refinement") is passed through a filter to separate and eliminate ionic impurities (anionic impurities and/or cationic impurities) from the solution for refinement by the filter, and the solvent (or the dispersion medium) is then removed, to thereby refine the hole transport material. By doing so, the amount of the ionic impurities contained in the hole transport layer 41 or the hole transport material is adjusted so as to lie within the above-described range.

When the solution for refinement is prepared, the same solvents (or dispersion media) that have been mentioned with reference to the method for manufacturing the organic EL device 1 (process of forming the hole transport layer 41) can be used.

As for a filter to be used in the filtration method, various filters can be used. In the case of cationic impurities, a filter formed using a cation-exchange resin as its main component is suitably used, and in the case of anionic impurities, a filter formed using an anion-exchange resin as its main component is suitably used. By using such a filter, it is possible to efficiently eliminate target ionic impurities from the hole transport material.

Examples of such a cation-exchange resin include strongly acidic cation-exchange resins, weakly acidic cation-exchange resins, and chelating resins capable of selectively eliminating heavy metals. For example, those obtained by introducing various functional groups such as -SO₃M, -COOM, and -N=(CH₂COO)₂M into main chains of various polymers such as styrene-based polymers, methacrylic polymers and acrylic polymers can be used. In this regard, it is to be noted that the functional group is appropriately selected depending on the kind of cation-exchange resin, and the like.

On the other hand, examples of such an anion-exchange resin include strongest basic anion-exchange resins, strongly basic anion-exchange resins, medium basic anion-exchange resins, and weakly basic anion-exchange resins. For example, those obtained by introducing various functional groups such as quaternary ammonium base and tertiary amine into main chains of various polymers such as styrene-based polymers and acrylic polymers can be used. In this regard, it is to be noted that the functional group is appropriately selected depending on the kind of anion-exchange resin, and the like.

The rate at the time when the solution for refinement is passed through a filter (hereinafter, referred to as "liquid passage rate" ) is not limited to any specific value, but is preferably in the range of about 1 to 1,000 mL/min, more preferably in the range of about 50 to 100 mL/min. By setting the liquid passage rate of the solution for refinement to a value within the above range, it is possible to more efficiently carry out the elimination of ionic impurities.

Further, the temperature of the solution for refinement (hereinafter, referred to as "solution temperature") is also not limited to any specific value, but it is preferred that the temperature is as high as possible within the range that does not interfere with the operation for eliminating ionic impurities. Namely, the solution temperature is preferably in the range of about 0 to 80°C, more preferably in the range of about 10 to 25°C. By setting the solution temperature to a value within the above range, it is possible to more efficiently carry out the elimination of ionic impurities.

In this case, the solution for refinement may be passed through a filter not only once but also two or more times, or it may also be passed through different kinds of two or more filters. Further, these filtering operations may be carried out in combination. By doing so, it is possible to more efficiently eliminate ionic impurities.

In this regard, it is to be noted that the solution for refinement after the refining process may be used for manufacturing the organic EL device 1 as it is without removing the solvent (or dispersion medium).

When the volume resistivity of the hole transport material obtained in such a manner as described above is measured, the volume resistivity thereof is preferably 10 Ω·cm or more, more preferably 10² Ω·cm or more. This enables an organic EL device 1 having higher light emitting efficiency to be obtained.

Although the hole transport material and the method of manufacturing the hole transport material according to the present invention have been described, it should be understood that the present invention are not limited thereto.

### Examples

Next, actual examples of the present invention will be described.

### <Refinement of hole transport material>

### (Example 1)

A 2.0 wt% aqueous soloution of poly(3,4-ethylenedioxythiophene/styrenesulfonic acid) solution (which is a hole transport material and is manufactured by Bayer Corp. under the product name of "Baytron P" ) was prepared as a solution for refinement.

Next, this solution for refinement was passed through a column provided with six filters at a solution temperature of 20°C and at a liquid passage rate of 50 mL/min, to eliminate anionic impurities.

In this regard, it is to be noted that all of the filters were made of a styrene-based quaternary ammonium salt-type strongest basic anion-exchange resin.

Next, a solvent in the solution for refinement that has been passed through the filters was volatilized to remove it, to thereby obtain a refined hole transport material.

### (Example 2)

Refinement of a hole transport material was carried out in the same manner as in Example 1 except that all of the six filters were replaced with filters made of a styrene-based ethanolamine (quaternary ammonium salt)-type strongly basic anion-exchange resin.

### (Example 3)

Refinement of a hole transport material was carried out in the same manner as in Example 1 except that all of the six filters were replaced with filters made of an acrylic quaternary ammonium salt-type medium basic anion-exchange resin.

### (Example 4)

Refinement of a hole transport material was carried out in the same manner as in Example 1 except that all of the six filters were replaced with filters made of an acrylic tertiary amine-type weakly basic anion-exchange resin.

### (Example 5)

Refinement of a hole transport material was carried out in the same manner as in Example 1 except that the six filters were replaced with three filters that were the same as those of Example 1 and three filters that were the same as those of Example 2.

### (Example 6)

Refinement of a hole transport material was carried out in the same manner as in Example 1 except that the six filters were replaced with three filters that were the same as those of Example 1 and three filters that were the same as those of Example 3.

### (Example 7)

Refinement of a hole transport material was carried out in the same manner as in Example 1 except that the six filters were replaced with three filters that were the same as those of Example 1 and three filters that were the same as those of Example 4.

### (Example 8)

Refinement of a hole transport material was carried out in the same manner as in Example 1 except that the six filters were replaced with three filters that were the same as those of Example 2 and three filters that were the same as those of Example 3.

### (Example 9)

Refinement of a hole transport material was carried out in the same manner as in Example 1 except that the six filters were replaced with three filters that were the same as those of Example 2 and three filters that were the same as those of Example 4.

### (Example 10)

Refinement of a hole transport material was carried out in the same manner as in Example 1 except that the six filters were replaced with three filters that were the same as those of Example 3 and three filters that were the same as those of Example 4.

### (Examples 11 to 20)

Refinements of hole transport materials were carried out in the same manner as in Examples 1 to 10, respectively, except that a hole transport material obtained by mixing the same hole transport material as that of Example 1 with polyaniline (having a weight average molecular weight of 20,000) in a ratio of 90:10 (weight ratio) was used as a hole transport material in each of Examples 11 to 20. In this regard, it is to be noted that the hole transport material was dissolved in pure water as a solvent so that the concentration thereof became 2.0 wt%.

### (Examples 21 to 30)

Refinements of hole transport materials were carried out in the same manner as in Examples 1 to 10, respectively, except that a hole transport material obtained by mixing the same hole transport material as that of Example 1 with N,N,N',N'-tetraphenylbenzidine in a ratio of 90:10 (weight ratio) was used as a hole transport material in each of Examples 21 to 30. In this regard, it is to be noted that the hole transport material was dissolved in a pure water-methanol mixture as a solvent so that the concentration thereof became 2.0 wt%.

### (Examples 31 to 40)

Refinements of hole transport materials were carried out in the same manner as in Examples 1 to 10, respectively, except that a hole transport material obtained by mixing the same hole transport material as that of Example 1 with N,N,N',N'-tetraphenylbenzidine and N,N'-di(naphthalene-1-yl)-N,N'-diphenyl-benzidine in a ratio of 92:5:3 (weight ratio) was used as a hole transport material in each of Examples 31 to 40. In this regard, it is to be noted that the hole transport material was dissolved in a pure water-methanol mixture as a solvent so that the concentration thereof became 2.0 wt%.

### (Example 41)

A solution for refinement was prepared in the same manner as in Example 1.

Then, this solution for refinement was passed through a column provided with six filters at a solution temperature of 20°C and at a liquid passage rate of 50 mL/min, to eliminate cationic impurities.

It is to be noted that all of the filters were made of a styrene-based sulfonic acid-type strongly acidic cation-exchange resin.

Next, a solvent in the solution for refinement that has been passed through the filters was volatilized to remove it, to thereby obtain a refined hole transport material.

### (Example 42)

Refinement of a hole transport material was carried out in the same manner as in Example 41 except that all of the six filters were replaced with filters made of a methacrylic carboxylic acid-type weakly acidic cation-exchange resin.

### (Example 43)

Refinement of a hole transport material was carried out in the same manner as in Example 41 except that all of the six filters were replaced with filters made of an acrylic carboxylic acid-type weakly acidic cation-exchange resin.

### (Example 44)

Refinement of a hole transport material was carried out in the same manner as in Example 41 except that the six filters were replaced with three filters that were the same as those of Example 41 and three filters that were the same as those of Example 42.

### (Example 45)

Refinement of a hole transport material was carried out in the same manner as in Example 41 except that the six filters were replaced with three filters that were the same as those of Example 41 and three filters that were the same as those of Example 43.

### (Example 46)

Refinement of a hole transport material was carried out in the same manner as in Example 41 except that the six filters were replaced with three filters that were the same as those of Example 42 and three filters that were the same as those of Example 43.

### (Example 47)

Refinement of a hole transport material was carried out in the same manner as in Example 41 except that the six filters were replaced with two filters that were the same as those of Example 41, two filters that were the same as those of Example 42, and two filters that were the same as those of Example 43.

### (Example 48)

Refinement of a hole transport material was carried out in the same manner as in Example 41 except that the six filters were replaced with two filters that were the same as those of Example 41, two filters that were the same as those of Example 42, and two filters made of a styrene-based iminodiacetic acid-type chelating resin.

### (Example 49)

Refinement of a hole transport material was carried out in the same manner as in Example 41 except that the six filters were replaced with two filters that were the same as those of Example 41, two filters that were the same as those of Example 43, and two filters made of a styrene-based iminodiacetic acid-type chelating resin.

### (Example 50)

Refinement of a hole transport material was carried out in the same manner as in Example 41 except that the six filters were replaced with two filters that were the same as those of Example 42, two filters that were the same as those of Example 43, and two filters made of a styrene-based iminodiacetic acid-type chelating resin.

### (Example 51)

A solution for refinement was prepared in the same manner as in Example 1.

Refinement of a hole transport material was carried out using this solution for refinement through the filtering processes of Example 1 and Example 41 in combination (for eliminating both of the anionic impurities and the cationic impurities).

### (Comparative Example 1)

A solution for refinement was prepared in the same manner as in Example 1.

Refinement of a hole transport material was carried out using this solution for refinement in the same manner as in Example 1 except that the six filters were replaced with two filters that were the same as those of Example 1 and one filter that was the same as that of Example 2.

### (Comparative Example 2)

A solution for refinement was prepared in the same manner as in Example 1.

Refinement of a hole transport material was carried out using this solution for refinement in the same manner as in Example 1 except that the six filters were replaced with two filters that were the same as those of Example 2 and one filter that was the same as that of Example 4.

### (Comparative Example 3)

Although the same hole transport material as that of Example 1 was prepared, refinement of the hole transport material was omitted.

### (Comparative Example 4)

Although the same hole transport material as that of Example 11 was prepared, refinement of the hole transport material was omitted.

### (Comparative Example 5)

Although the same hole transport material as that of Example 21 was prepared, refinement of the hole transport material was omitted.

### (Comparative Example 6)

Although the same hole transport material as that of Example 31 was prepared, refinement of the hole transport material was omitted.

### (Comparative Example 7)

A solution for refinement was prepared in the same manner as in Example 1.

Refinement of a hole transport material was carried out using this solution for refinement in the same manner as in Example 41 except that the six filters were replaced with two filters that were the same as those of Example 41.

### (Comparative Example 8)

A solution for refinement was prepared in the same manner as in Example 1.

Refinement of a hole transport material was carried out using this solution for refinement in the same manner as in Example 41 except that the six filters were replaced with one filter that was the same as that of Example 41 and one filter made of a styrene-based iminodiacetic acid-type chelating resin.

### <Evaluation>

### 1. Measurement of amount of ionic impurities

### 1-1. Measurement of amount of anionic impurities

The amount of the anionic impurities contained in the refined hole transport material obtained in each of Examples 1 to 40 and 51, and the amount of the anionic impurities contained in the hole transport material of each of Comparative Examples 1 to 6 were measured using an Ion Chromatography method (IC method), respectively.

Specifically, each hole transport material was dissolved in pure water or a pure water-methanol mixture so that the concentration thereof became 2.0 wt%, to obtain a solution. This solution was analyzed by an IC method.

In this regard, it is to be noted that no anionic impurities were detected in the pure water and methanol used here.

Further, the amount of anionic impurities contained in the hole transport layer of each organic EL device, which will be described later, was determined by calculating a measurement values obtained here.

### 1-2. Measurement of amount of cationic impurities

The amount of the cationic impurities contained in the refined hole transport material obtained in each of Examples 41 to 51, and the amount of cationic impurities contained in the hole transport material of each of Comparative Examples 3, 7 and 8 were measured using an Inductively coupled plasma mass spectroscopy method (ICP-MS method), respectively.

Specifically, 0.5 g of a solution obtained by dissolving the hole transport material in pure water or a pure water-methanol mixture so that the concentration thereof became 2.0 wt% was weighed in a quartz crucible, and an ashing treatment was successively carried out with a hot plate and an electric furnace. Next, the ashed matter was subjected to thermolysis using nitric acid, and was then made up to a constant volume with dilute nitric acid. The obtained solution with a constant volume was analyzed by an ICP-MS method.

In this regard, it is to be noted that no cationic impurities were detected in the pure water and methanol used here.

The analytical results were evaluated according to the following seven criteria depending on the amount of the cationic impurities.

Further, the amount of cationic impurities contained in the hole transport layer of each organic EL device, which will be described later, was determined by calculating the measurement values obtained here.

### <Amount of cationic impurities contained in 2.0 wt% solution>

- -:: 0.1 ppm or less
- +:: more than 0.1 ppm but 1 ppm or less
- 2+:: more than 1 ppm but 5 ppm or less
- 3+:: more than 5 ppm but 10 ppm or less
- 4+:: more than 10 ppm but 30 ppm or less
- 5+:: more than 30 ppm but 500 ppm or less
- 6+:: more than 500 ppm

### <Amount of cationic impurities contained in hole transport layer>

- -:: 5 ppm or less
- +:: more than 5 ppm but 50 ppm or less
- 2+:: more than 50 ppm but 250 ppm or less
- 3+:: more than 250 ppm but 500 ppm or less
- 4+:: more than 500 ppm but 1,500 ppm or less
- 5+:: more than 1,500 ppm but 25,000 ppm or less
- 6+:: more than 25,000 ppm

### 2. Evaluation of decrease of light-emission luminance of organic EL device

Organic EL devices were manufactured in the following manner using the refined hole transport materials obtained in Examples 1 to 51 and the hole transport materials of Comparative Examples 1 to 8, respectively.

First, a transparent glass substrate having an average thickness of 0.5 mm was prepared.

Next, an ITO electrode (anode) having an average thickness of 100 nm was formed on the substrate by a vacuum deposition method.

Next, a solution obtained by dissolving the hole transport material in pure water or a pure water-methanol mixture so that the concentration thereof became 2.0 wt% was applied on the ITO electrode by a spin coating method and was then dried, to form a hole transport layer having an average thickness of 50 nm.

Next, a xylene solution containing 1.7 wt% of poly(9,9-dioctyl-2,7-divinylenefluorenyl-alt-co(anthracene-9,10 - diyl) (having a weight average molecular weight of 200,000) was applied on the hole transport layer by a spin coating method and was then dried, to form a light emitting layer having an average thickness of 50 nm.

Next, an electron transport layer having an average thickness of 20 nm was formed on the light emitting layer by vacuum deposition of 3,4,5-triphenyl-1,2,4-triazole.

Next, an AlLi electrode (cathode) having an average thickness of 300 nm was formed on the electron transport layer by a vacuum deposition method.

Next, a protection cover made of polycarbonate was coated so as to cover the formed layers, and was fixed and sealed with an ultraviolet rays-curable resin, to complete the organic EL device.

A voltage of 6V was applied across the ITO electrode and the AlLi electrode of each of the organic EL devices manufactured in such a manner described above, and light-emission luminance was measured to determine the time elapsed before the initial value of light-emission luminance was decreased to half (a half-life).

The measurement results of the amounts of the ionic impurities and the evaluation results of decrease of light-emission luminance of each of the organic EL devices are shown in the following Tables 1 to 6.

It is to be noted that in each of Tables 1 to 6, Table A shows the amount of the impurities contained in each 2.0 wt% solution, and Table B shows the amount of the impurities contained in each hole transport layer.

Further, in each of Tables 1 to 4 and 6, the amount of each of the anionic impurities, that is, the amounts of SO₄²⁻, HCO₂⁻, C₂O₄²⁻ and CH₃CO₂⁻, and the total amount of the anionic impurities (other than SO₄²⁻) are shown.

Furthermore, in each of Tables 5 and 6, the amount of each of the cationic impurities, and the total amount of the cationic impurities are shown.

Moreover, the evaluation result of decrease of light-emission luminance of each organic EL device was shown by the relative value of half-life of light-emission luminance of the organic EL device manufactured using the hole transport material of each of Examples and Comparative Examples. In this regard, it is to be noted that each value was determined by defining the half-life of light-emission luminance of the organic EL device manufactured using the non-refined hole transport material of each of the corresponding Comparative Examples as "1".

**Table 1 (A)**

| <In 2.0 wt% solution> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 1 | 8.5 | 0.9 | 0.3 | 0.4 | 1.8 | 1.74 |
| Ex. 2 | 9.2 | 0.9 | 0.5 | 0.6 | 2.1 | 1.65 |
| Ex. 3 | 9.5 | 1.0 | 0.6 | 0.7 | 3.2 | 1.67 |
| Ex. 4 | 10.2 | 1.0 | 0.5 | 0.6 | 2.2 | 1.55 |
| Ex. 5 | 14.5 | 1.3 | 0.7 | 0.8 | 2.9 | 1.46 |
| Ex. 6 | 15.0 | 1.5 | 0.7 | 0.8 | 3.3 | 1.44 |
| Ex. 7 | 14.8 | 1.4 | 0.8 | 0.9 | 3.1 | 1.42 |
| Ex. 8 | 14.6 | 1.4 | 0.7 | 0.8 | 3.0 | 1.48 |
| Ex. 9 | 19.8 | 1.9 | 1.0 | 1.1 | 4.0 | 1.21 |
| Ex. 10 | 20.0 | 1.8 | 0.9 | 1.0 | 3.7 | 1.23 |
| Com. Ex. 1 | 24.9 | 2.4 | 1.1 | 1.2 | 11.4 | 1.02 |
| Com. Ex. 2 | 38.9 | 3.5 | 2.1 | 2.2 | 12.3 | 1.02 |
| Com. Ex. 3 | 59.5 | 5.2 | 4.3 | 4.4 | 16.5 | 1.00 |

**Table 1 (B)**

| <In hole transport layer> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 1 | 425 | 45 | 15 | 20 | 90 | 1.74 |
| Ex. 2 | 460 | 45 | 25 | 30 | 105 | 1.65 |
| Ex. 3 | 475 | 50 | 30 | 35 | 160 | 1.67 |
| Ex. 4 | 510 | 50 | 25 | 30 | 110 | 1.55 |
| Ex. 5 | 725 | 65 | 35 | 40 | 145 | 1.46 |
| Ex. 6 | 750 | 75 | 35 | 40 | 165 | 1.44 |
| Ex. 7 | 740 | 70 | 40 | 45 | 155 | 1.42 |
| Ex. 8 | 730 | 70 | 35 | 40 | 150 | 1.48 |
| Ex. 9 | 990 | 95 | 50 | 55 | 200 | 1.21 |
| Ex. 10 | 1,000 | 90 | 45 | 50 | 185 | 1.23 |
| Com. Ex. 1 | 1,245 | 120 | 55 | 60 | 570 | 1.02 |
| Com. Ex. 2 | 1,945 | 175 | 105 | 110 | 615 | 1.02 |
| Com. Ex. 3 | 2,975 | 260 | 215 | 220 | 825 | 1.00 |

**Table 2 (A)**

| <In 2.0 wt% solution> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 11 | 8.2 | 0.9 | 0.3 | 0.4 | 1.8 | 1.70 |
| Ex. 12 | 9.3 | 0.9 | 0.6 | 0.6 | 2.2 | 1.67 |
| Ex. 13 | 9.7 | 1.0 | 0.5 | 0.6 | 2.3 | 1.60 |
| Ex. 14 | 11.2 | 1.1 | 0.6 | 0.5 | 2.3 | 1.45 |
| Ex. 15 | 14.2 | 1.2 | 0.8 | 0.7 | 2.9 | 1.35 |
| Ex. 16 | 15.0 | 1.5 | 0.7 | 0.6 | 2.9 | 1.33 |
| Ex. 17 | 14.8 | 1.4 | 0.7 | 0.6 | 2.8 | 1.34 |
| Ex. 18 | 14.6 | 1.2 | 0.7 | 0.6 | 2.8 | 1.32 |
| Ex. 19 | 18.8 | 1.9 | 1.0 | 1.1 | 4.1 | 1.18 |
| Ex. 20 | 18.0 | 1.7 | 0.9 | 1.0 | 3.6 | 1.17 |
| Com. Ex. 4 | 57.5 | 5.2 | 4.5 | 4.5 | 15.5 | 1.00 |

**Table 2 (B)**

| <In hole transport layer> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 11 | 410 | 45 | 15 | 20 | 90 | 1.70 |
| Ex. 12 | 465 | 45 | 30 | 30 | 110 | 1.67 |
| Ex. 13 | 485 | 50 | 25 | 30 | 115 | 1.60 |
| Ex. 14 | 560 | 55 | 30 | 25 | 115 | 1.45 |
| Ex. 15 | 710 | 60 | 40 | 35 | 145 | 1.35 |
| Ex. 16 | 750 | 75 | 35 | 30 | 145 | 1.33 |
| Ex. 17 | 740 | 70 | 35 | 30 | 140 | 1.34 |
| Ex. 18 | 730 | 60 | 35 | 30 | 140 | 1.32 |
| Ex. 19 | 940 | 95 | 50 | 55 | 205 | 1.18 |
| Ex. 20 | 900 | 85 | 45 | 50 | 180 | 1.17 |
| Com. Ex. 4 | 2,875 | 260 | 225 | 225 | 775 | 1.00 |

**Table 3 (A)**

| <In 2.0 wt% solution> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 21 | 8.1 | 0.9 | 0.3 | 0.2 | 1.6 | 1.73 |
| Ex. 22 | 9.4 | 0.9 | 0.6 | 0.2 | 1.8 | 1.68 |
| Ex. 23 | 9.5 | 1.0 | 0.5 | 0.4 | 2.1 | 1.53 |
| Ex. 24 | 10.2 | 1.1 | 0.6 | 0.4 | 2.2 | 1.39 |
| Ex. 25 | 14.2 | 1.1 | 0.8 | 0.8 | 2.8 | 1.31 |
| Ex. 26 | 15.0 | 1.5 | 0.7 | 0.7 | 3.2 | 1.33 |
| Ex. 27 | 15.8 | 1.3 | 0.8 | 0.7 | 2.8 | 1.34 |
| Ex. 28 | 15.6 | 1.1 | 0.7 | 0.7 | 2.6 | 1.35 |
| Ex. 29 | 18.4 | 1.9 | 1.0 | 1.0 | 4.0 | 1.15 |
| Ex. 30 | 18.3 | 1.7 | 0.9 | 1.0 | 3.9 | 1.17 |
| Com. Ex. 5 | 54.5 | 5.6 | 4.4 | 4.4 | 16.9 | 1.00 |

**Table 3 (B)**

| <In hole transport layer> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 21 | 405 | 45 | 15 | 10 | 80 | 1.73 |
| Ex. 22 | 470 | 45 | 30 | 10 | 90 | 1.68 |
| Ex. 23 | 475 | 50 | 25 | 20 | 105 | 1.53 |
| Ex. 24 | 510 | 55 | 30 | 20 | 110 | 1.39 |
| Ex. 25 | 710 | 55 | 40 | 40 | 140 | 1.31 |
| Ex. 26 | 750 | 75 | 35 | 35 | 160 | 1.33 |
| Ex. 27 | 790 | 65 | 40 | 35 | 140 | 1.34 |
| Ex. 28 | 780 | 55 | 35 | 35 | 130 | 1.35 |
| Ex. 29 | 920 | 95 | 50 | 50 | 200 | 1.15 |
| Ex. 30 | 915 | 85 | 45 | 50 | 195 | 1.17 |
| Com. Ex. 5 | 2,725 | 280 | 220 | 220 | 845 | 1.00 |

**Table 4 (A)**

| <In 2.0 wt% solution> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 31 | 7.9 | 0.7 | 0.3 | 0.2 | 1.3 | 1.74 |
| Ex. 32 | 9.3 | 0.7 | 0.5 | 0.3 | 1.6 | 1.69 |
| Ex. 33 | 9.8 | 1.0 | 0.7 | 0.3 | 2.2 | 1.55 |
| Ex. 34 | 11.2 | 1.2 | 0.5 | 0.3 | 2.1 | 1.40 |
| Ex. 35 | 14.4 | 1.2 | 0.7 | 0.4 | 2.4 | 1.35 |
| Ex. 36 | 15.2 | 1.7 | 0.7 | 0.5 | 3.2 | 1.33 |
| Ex. 37 | 14.8 | 1.4 | 0.5 | 0.3 | 2.2 | 1.35 |
| Ex. 38 | 13.6 | 1.2 | 0.9 | 0.7 | 2.9 | 1.38 |
| Ex. 39 | 19.4 | 2.0 | 1.0 | 1.0 | 4.0 | 1.13 |
| Ex. 40 | 19.3 | 1.4 | 0.7 | 0.7 | 3.1 | 1.12 |
| Com. Ex. 6 | 52.5 | 5.2 | 4.8 | 4.8 | 16.3 | 1.00 |

**Table 4 (B)**

| <In hole transport layer> | | | | | | |
|---|---|---|---|---|---|---|
| | Amount of anionic impurities (ppm) | | | | | Evaluation of decrease of light-emission luminance |
| | SO₄²⁻ | Other than SO₄²⁻ | | | | Half-life (Relative value) |
| | | HCO₂⁻ | C₂O₄²⁻ | CH₃CO₂⁻ | Total | |
| Ex. 31 | 395 | 35 | 15 | 10 | 65 | 1.74 |
| Ex. 32 | 465 | 35 | 25 | 15 | 80 | 1.69 |
| Ex. 33 | 490 | 50 | 35 | 15 | 110 | 1.55 |
| Ex. 34 | 560 | 60 | 25 | 15 | 105 | 1.40 |
| Ex. 35 | 720 | 60 | 35 | 20 | 120 | 1.35 |
| Ex. 36 | 760 | 85 | 35 | 25 | 160 | 1.33 |
| Ex. 37 | 740 | 70 | 25 | 15 | 110 | 1.35 |
| Ex. 38 | 680 | 60 | 45 | 35 | 145 | 1.38 |
| Ex. 39 | 970 | 100 | 50 | 50 | 200 | 1.13 |
| Ex. 40 | 965 | 70 | 35 | 35 | 155 | 1.12 |
| Com. Ex. 6 | 2,625 | 260 | 240 | 240 | 815 | 1.00 |

**Table 5 (A)**

| <In 2.0 wt% solution> | | | | | | | | | | | | |
|---|---|---|---|---|---|---|---|---|---|---|---|---|
| | Amount of cationic impurities | | | | | | | | | | | Evaluation of decrease of light-emission luminance |
| | Na | Mg | K | Ca | Cr | Mn | Fe | Ni | Zn | Sr | Total | Half-life (Relative value) |
| Ex. 41 | - | - | - | + | - | - | - | - | - | - | 2+ | 1.79 |
| Ex. 42 | + | + | + | + | + | - | + | + | + | + | 3+ | 1.55 |
| Ex. 43 | + | + | + | + | + | + | + | + | + | + | 3+ | 1.51 |
| Ex. 44 | + | + | + | + | + | + | + | + | + | + | 3+ | 1.53 |
| Ex. 45 | + | + | + | + | + | + | + | + | + | + | 3+ | 1.54 |
| Ex. 46 | 2+ | + | + | 2+ | + | + | + | + | + | + | 4+ | 1.41 |
| Ex. 47 | 2+ | + | + | 2+ | + | + | + | + | + | + | 4+ | 1.39 |
| Ex. 48 | 3+ | + | + | 3+ | 2+ | + | + | + | + | + | 4+ | 1.29 |
| Ex. 49 | 2+ | + | + | 3+ | 2+ | + | + | + | + | + | 4+ | 1.27 |
| Ex. 50 | 3+ | + | + | 3+ | + | + | + | + | + | + | 4+ | 1.31 |
| Com. Ex. 7 | 4+ | + | + | 3+ | 2+ | + | 2+ | + | + | + | 6+ | 1.08 |
| Com. Ex. 8 | 5+ | + | + | 3+ | 2+ | + | 2+ | + | | + | 6+ | 1.03 |
| Com. Ex. 3 | 6+ | + | + | 3+ | 3+ | + | 3+ | + | + | + | 6+ | 1.00 |
| -: 0.1 ppm or less | | | | | | | | | | | | |
| +: more than 0.1 ppm but 1 ppm or less | | | | | | | | | | | | |
| 2+: more than 1 ppm but 5 ppm or less | | | | | | | | | | | | |
| 3+: more than 5 ppm but 10 ppm or less | | | | | | | | | | | | |
| 4+: more than 10 ppm but 30 ppm or less | | | | | | | | | | | | |
| 5+: more than 30 ppm but 500 ppm or less | | | | | | | | | | | | |
| 6+: more than 500 ppm | | | | | | | | | | | | |

**Table 5 (B)**

| <In hole transport layer> | | | | | | | | | | | | |
|---|---|---|---|---|---|---|---|---|---|---|---|---|
| | Amount of cationic impurities | | | | | | | | | | | Evaluation of decrease of light-emission luminance |
| | Na | Mg | K | Ca | Cr | Mn | Fe | Ni | Zn | Sr | Total | Half-life (Relative value) |
| Ex. 41 | - | - | - | + | - | - | - | - | - | - | 2+ | 1.79 |
| Ex. 42 | + | + | + | + | + | - | + | + | + | + | 3+ | 1.55 |
| Ex. 43 | + | + | + | + | + | + | + | + | + | + | 3+ | 1.51 |
| Ex. 44 | + | + | + | + | + | + | + | + | + | + | 3+ | 1.53 |
| Ex. 45 | + | + | + | + | + | + | + | + | + | + | 3+ | 1.54 |
| Ex. 46 | 2+ | + | + | 2+ | + | + | + | + | + | + | 4+ | 1.41 |
| Ex. 47 | 2+ | + | + | 2+ | + | + | + | + | + | + | 4+ | 1.39 |
| Ex. 48 | 3+ | + | + | 3+ | 2+ | + | + | + | + | + | 4+ | 1.29 |
| Ex. 49 | 2+ | + | + | 3+ | 2+ | + | + | + | + | + | 4+ | 1.27 |
| Ex. 50 | 3+ | + | + | 3+ | + | + | + | + | + | + | 4+ | 1.31 |
| Com. Ex. 7 | 4+ | + | + | 3+ | 2+ | + | 2+ | + | + | + | 6+ | 1.08 |
| Com. Ex. 8 | 5+ | + | + | 3+ | 2+ | + | 2+ | + | + | + | 6+ | 1.03 |
| Com. Ex. 3 | 6+ | + | + | 3+ | 3+ | + | 3+ | + | + | + | 6+ | 1.00 |
| -: 5 ppm or less | | | | | | | | | | | | |
| +: more than 5 ppm but 50 ppm or less | | | | | | | | | | | | |
| 2+: more than 50 ppm but 250 ppm or less | | | | | | | | | | | | |
| 3+: more than 250 ppm but 500 ppm or less | | | | | | | | | | | | |
| 4+: more than 500 ppm but 1,500 ppm or less | | | | | | | | | | | | |
| 5+: more than 1,500 ppm but 25,000 ppm or less | | | | | | | | | | | | |
| 6+: more than 25,000 ppm | | | | | | | | | | | | |

**Table 6 (A)**

| <In 2.0 wt% solution> | | | | | |
|---|---|---|---|---|---|
| | Amount of anionic impurities (ppm) | | | | |
| | SO₄²⁻ | Other than SO₄²⁻ | | | |
| | | HCO₂⁻ | C₂O₄²⁻ | CH₃CO₂⁻ | Total |
| Ex. 1 | 8.5 | 0.9 | 0.3 | 0.4 | 1.8 |
| Ex. 41 | Not measured | | | | |
| Ex. 51 | 7.9 | 0.7 | 0.2 | 0.1 | 1.3 |
| Com. Ex. 3 | 59.5 | 5.2 | 4.3 | 4.4 | 16.5 |

| | Amount of cationic impurities | | | | | | | | | | | Evaluation of decrease of light-emission luminance |
|---|---|---|---|---|---|---|---|---|---|---|---|---|
| | Na | Mg | K | Ca | Cr | Mn | Fe | Ni | Zn | Sr | Total | Half-life (Relative value) |
| Ex. 1 | Not measured | | | | | | | | | | | 1.74 |
| Ex. 41 | - | - | - | + | - | - | - | - | - | - | 2+ | 1.79 |
| Ex. 51 | - | - | - | + | - | - | - | - | - | - | 2+ | 1.99 |
| Com. Ex. 3 | 6+ | + | + | 3+ | 3+ | + | 3+ | + | + | + | 6+ | 1.00 |
| -: 0.1 ppm or less | | | | | | | | | | | | |
| +: more than 0.1 ppm but 1 ppm or less | | | | | | | | | | | | |
| 2+: more than 1 ppm but 5 ppm or less | | | | | | | | | | | | |
| 3+: more than 5 ppm but 10 ppm or less | | | | | | | | | | | | |
| 4+: more than 10 ppm but 30 ppm or less | | | | | | | | | | | | |
| 5+: more than 30 ppm but 500 ppm or less | | | | | | | | | | | | |
| 6+: more than 500 ppm | | | | | | | | | | | | |

**Table 6 (B)**

| <In hole transport layer> | | | | | |
|---|---|---|---|---|---|
| | Amount of anionic impurities (ppm) | | | | |
| | SO₄²⁻ | Other than SO₄²⁻ | | | |
| | | HCO₂⁻ | C₂O²⁻ | CH₃CO²⁻ | Total |
| Ex. 1 | 425 | 45 | 15 | 20 | 90 |
| Ex. 41 | Not measured | | | | |
| Ex. 51 | 395 | 35 | 10 | 5 | 65 |
| Com. Ex. 3 | 2,975 | 260 | 215 | 220 | 825 |

| | Amount of cationic impurities | | | | | | | | | | | Evaluation of decrease of light-emission luminance |
|---|---|---|---|---|---|---|---|---|---|---|---|---|
| | Na | Mg | K | Ca | Cr | Mn | Fe | Ni | Zn | Sr | Total | Half-life (Relative value) |
| Ex. 1 | Not measured | | | | | | | | | | | 1.74 |
| Ex. 41 | - | - | - | + | - | - | - | - | - | - | 2+ | 1.79 |
| Ex. 51 | - | - | - | + | - | - | - | - | - | - | 2+ | 1.99 |
| Com. Ex. 3 | 6+ | + | + | 3+ | 3+ | + | 3+ | + | + | + | 6+ | |
| -: 5 ppm or less | | | | | | | | | | | | |
| +: more than 5 ppm but 50 ppm or less | | | | | | | | | | | | |
| 2+: more than 50 ppm but 250 ppm or less | | | | | | | | | | | | |
| 3+: more than 250 ppm but 500 ppm or less | | | | | | | | | | | | |
| 4+: more than 500 ppm but 1,500 ppm or less | | | | | | | | | | | | |
| 5+: more than 1,500 ppm but 25,000 ppm or less | | | | | | | | | | | | |
| 6+: more than 25,000 ppm | | | | | | | | | | | | |

As shown in Tables 1 to 4 and 6, in the case of the refined hole transport material of each of Examples, the anionic impurities were reduced, and the amount of SO₄²⁻ contained therein was controlled to 20 ppm or less in the 2.0 wt% solution (1,000 ppm or less in the hole transport layer), and the amount of each of HCO₂⁻, C₂O₄²⁻, and CH₃CO₂⁻ was controlled to 2 ppm or less in the 2.0 wt% solution (100 ppm or less in the hole transport layer).

Further, in the case of the hole transport material of each of Examples, the amount of each of the anionic impurities other than SO₄²⁻ , HCO₂⁻, C₂O₄²⁻ and CH₃CO₂⁻ contained therein (not shown in Tables 1 to 4 and 6) was also 2 ppm or less in the 2.0 wt% solution (100 ppm or less in the hole transport layer).

Furthermore, in the case of the hole transport material of each of Examples, the total amount of the anionic impurities (other than SO₄²⁻) contained therein was controlled to 10 ppm or less in the 2.0 wt% solution (particularly 4.5 ppm or less) , and was controlled to 500 ppm or less in the hole transport layer (particularly 225 ppm or less).

On the other hand, in the case of the hole transport material of each of Comparative Examples, the amount of SO₄²⁻ contained therein exceeded 20 ppm in the 2.0 wt% solution (more than 1,000 ppm in the hole transport layer). Further, the amount of the anionic impurity of which content is the largest among the anionic impurities other than SO₄²⁻ exceeded 2 ppm in the 2.0 wt% solution (more than 100 ppm in the hole transport layer), and the total amount of the anionic impurities (other than SO₄²⁻) also exceeded 10 ppm in the 2.0 wt% solution (more than 500 ppm in the hole transport layer).

On the other hand, as shown in Tables 5 and 6, in the case of the refined hole transport material of each of Examples, the cationic impurities were reduced, and each of the cationic impurities was controlled to 10 ppm or less in the 2.0 wt% solution (500 ppm or less in the hole transport layer).

Further, in the case of the hole transport material of each of Examples, the total amount of the cationic impurities was also controlled to 30 ppm or less in the 2.0 wt% solution (1,500 ppm or less in the hole transport layer).

On the other hand, in the case of the hole transport material of each of Comparative Examples, the amount of the cationic impurity of which content is the largest among the cationic impurities exceeded 10 ppm in the 2.0 wt% solution (more than 500 ppm in the hole transport layer), and the total amount of the cationic impurities exceeded 500 ppm in the 2.0 wt% solution (more than 25,000 ppm in the hole transport layer) , and far exceeded 30 ppm in the 2.0 wt% solution (more than 1,500 ppm in the hole transport layer).

In this connection, it is to be noted that the volume resistivity of the hole transport material of each of Examples was larger than that of the hole transport material of each of Comparative Examples, and was 10⁴ Ω·cm or larger.

Further, the organic EL device manufactured using the hole transport material of each of Examples had a longer half-life of light-emission luminance as compared with the organic EL device manufactured using the hole transport material of each of Comparative Examples, that is, the decrease of light-emission luminance was suppressed.

Furthermore, each of Tables shows a tendency that the half-life of light-emission luminance of the organic EL device is prolonged as the amount of the anionic impurities and cationic impurities is reduced.

Furthermore, as shown in Table 6, the organic EL device manufactured using the hole transport material of Example 51, from which both of the anionic impurities and the cationic impurities were eliminated, had a conspicuously long half-life of light-emission luminance.

As described above, it has been found that an organic EL device using the hole transport material of the present invention, in which the amount of the anionic impurities and/or cationic impurities is controlled to a predetermined value, is excellent one. That is, in such an organic EL device, the decrease of light-emission luminance is suppressed and excellent light emitting properties are maintained for a long period of time.

Finally, it is to be noted that the present invention is not limited to the embodiments and examples described above, and any additions or changes may be made without departing from the scope of the present invention.

## Claims

1. A hole transport material to be used for a layer having the function of transporting holes in an organic EL device, the hole transport material being **characterized in that** when the layer is formed using the hole transport material, an amount of sulfate ions contained in the layer is 1000 ppm or less.

2. The hole transport material as claimed in claim 1, wherein when the volume resistivity of the hole transport material is measured, it is 10 Ω·cm or larger.

3. The hole transport material as claimed in claim 1, wherein the hole transport material contains a low-molecular hole transport material.

4. The hole transport material as claimed in claim 1, wherein the hole transport material contains a high-molecular hole transport material.

5. The hole transport material as claimed in claim 1, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

6. A hole transport material to be used for a layer having the function of transporting holes in an organic EL device, the layer containing one or more kinds of anionic impurities other than sulfate ions, wherein the hole transport material being **characterized in that** when the layer is formed using the hole transport material, an amount of the anionic impurity of which content is the largest among the anionic impurities is 100 ppm or less.

7. The hole transport material as claimed in claim 6, wherein the total amounts of the anionic impurities contained in the layer is 500 ppm or less.

8. The hole transport material as claimed in claim 6, wherein when the volume resistivity of the hole transport material is measured, it is 10 Ω·cm or larger.

9. The hole transport material as claimed in claim 6, wherein the hole transport material contains a low-molecular hole transport material.

10. The hole transport material as claimed in claim 6, wherein the hole transport material contains a high-molecular hole transport material.

11. The hole transport material as claimed in claim 6, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

12. A hole transport material to be used for a layer having the function of transporting holes in an organic EL device, the layer containing one or more kinds of cationic impurities, wherein the hole transport material being **characterized in that** when the layer is formed using the hole transport material, an amount of the cationic impurity of which content is the largest among the cationic impurities is 500 ppm or less.

13. The hole transport material as claimed in claim 12, wherein the total amounts of the cationic impurities contained in the layer is 1500 ppm or less.

14. The hole transport material as claimed in claim 12, wherein the cationic impurities include metal ions.

15. The hole transport material as claimed in claim 12, wherein when the volume resistivity of the hole transport material is measured, it is 10 Ω·cm or larger.

16. The hole transport material as claimed in claim 12, wherein the hole transport material contains a low-molecular hole transport material.

17. The hole transport material as claimed in claim 12, wherein the hole transport material contains a high-molecular hole transport material.

18. The hole transport material as claimed in claim 12, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

19. A hole transport material to be used for a layer having the function of transporting holes in an organic EL device, wherein the hole transport material is **characterized in that** when the hole transport material is dissolved or dispersed in a liquid so that the concentration thereof becomes 2.0 wt%, the liquid contains sulfate ions, but an amount of the sulfate ions is 20 ppm or less.

20. The hole transport material as claimed in claim 19, wherein when the volume resistivity of the hole transport material is measured, it is 10 Ω·cm or larger.

21. The hole transport material as claimed in claim 19, wherein the hole transport material contains a low-molecular hole transport material.

22. The hole transport material as claimed in claim 19, wherein the hole transport material contains a high-molecular hole transport material.

23. The hole transport material as claimed in claim 19, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

24. A hole transport material to be used for a layer having the function of transporting holes in an organic EL device, the hole transport material being **characterized in that** when the hole transport material is dissolved or dispersed in a liquid so that the concentration thereof becomes 2.0 wt%, the liquid contains one or more kinds of anionic impurities other than sulfate ions, but an amount of the anionic impurity of which content is the largest among the anionic impurities is 2 ppm or less.

25. The hole transport material as claimed in claim 24, wherein the total amounts of the anionic impurities contained in the liquid is 10 ppm or less.

26. The hole transport material as claimed in claim 24, wherein when the volume resistivity of the hole transport material is measured, it is 10 Ω·cm or larger.

27. The hole transport material as claimed in claim 24, wherein the hole transport material contains a low-molecular hole transport material.

28. The hole transport material as claimed in claim 24, wherein the hole transport material contains a high-molecular hole transport material.

29. The hole transport material as claimed in claim 24, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

30. A hole transport material to be used for a layer having the function of transporting holes in an organic EL device, the hole transport material being **characterized in that** when the hole transport material is dissolved or dispersed in a liquid so that the concentration thereof becomes 2.0 wt%, the liquid contains one or more cationic impurities, but an amount of the cationic impurity of which content is the largest among the cationic impurities is 10 ppm or less.

31. The hole transport material as claimed in claim 30, wherein the cationic impurities include metal ions.

32. The hole transport material as claimed in claim 30, wherein when the volume resistivity of the hole transport material is measured, it is 10 Ω·cm or larger.

33. The hole transport material as claimed in claim 30, wherein the hole transport material contains a low-molecular hole transport material.

34. The hole transport material as claimed in claim 30, wherein the hole transport material contains a high-molecular hole transport material.

35. The hole transport material as claimed in claim 30, wherein the hole transport material is selected from the group comprising arylcycloalkane-based compounds arylamine-based compounds, phenylenediamine-based compounds, carbazole-based compounds, stilbene-based compounds, oxazole-based compounds, triphenylmethane-based compounds, pyrazoline-based compounds, benzine(cyclohexadiene)-based compounds, triazole-based compounds, imidazole-based compounds, oxadiazole-based compounds, anthracene-based compounds, fluorenone-based compounds, aniline-based compounds, silane-based compounds, thiophene-based compounds, pyrrole-based compounds, florene-based compounds, porphyrin-based compounds, quinacridon-based compounds, phthalocyanine-based compounds, naphthalocyanine-based compounds, and benzidine-based compounds.

36. A method of manufacturing a hole transport material to be used for a layer having the function of transporting holes in an organic EL device, wherein the method comprising the steps of:
preparing a liquid in which a hole transport material is dissolved or dispersed in a solvent or a dispersion medium; and
eliminating sulfate ions contained in the liquid by means of eliminating means which separates or eliminates the sulfate ions, and then removing the solvent or dispersion medium from the liquid, thereby refining the hole transport material,
wherein thus refined hole transport material is **characterized in that** when the layer having the function of transporting holes is formed using the hole transport material, an amount of sulfate ions contained in the layer is 1000 ppm or less.

37. A method of manufacturing a hole transport material to be used for a layer having the function of transporting holes in an organic EL device, the method comprising the steps of:
preparing a liquid in which a hole transport material is dissolved or dispersed in a solvent or a dispersion medium; and
eliminating one or more kinds of anionic impurities other than sulfate ions contained in the liquid by means of eliminating means which separates or eliminates the anionic impurities, and then removing the solvent or dispersion medium from the liquid, thereby refining the hole transport material,
wherein thus refined hole transport material is **characterized in that** when the layer is formed using the hole transport material, an amount of the anionic impurity of which content is the largest among the anionic impurities contained in the layer is 100 ppm or less.

38. A method of manufacturing a hole transport material to be used for a layer having the function of transporting holes in an organic EL device, the method comprising the steps of:
preparing a liquid in which a hole transport material is dissolved or dispersed in a solvent or a dispersion medium; and
eliminating one or more kinds of cationic impurities contained in the liquid by means of eliminating means which separates or eliminates the cationic impurities, and then removing the solvent or dispersion medium from the liquid, thereby refining the hole transport material,
wherein thus refined hole transport material is **characterized in that** when the layer is formed using the hole transport material, an amount of the cationic impurity of which content is the largest among the cationic impurities contained in the layer is 500 ppm or less.

39. A method of refining a hole transport material to be used for a layer having the function of transporting holes in an organic EL device, the method comprising the steps of:
preparing a liquid in which a hole transport material is dissolved or dispersed in a solvent or a dispersion medium;
eliminating sulfate ions contained in the liquid by means of eliminating means which separates or eliminates the sulfate ions, and then removing the solvent or dispersion medium from the liquid, thereby refining the hole transport material,
wherein thus refined hole transport material is **characterized in that** when the hole transport material is dissolved or dispersed in a liquid so that the concentration thereof becomes 2.0 wt%, an amount of sulfate ions contained in the liquid is 20 ppm or less.

40. A method of refining a hole transport material to be used for a layer having the function of transporting holes in an organic EL device, the method comprising the steps of:
preparing a liquid in which a hole transport material is dissolved or dispersed in a solvent or a dispersion medium;
eliminating one or more kinds of anionic impurities other than sulfate ions contained in the liquid by means of eliminating means which separates or eliminates the anionic impurities, and then removing the solvent or dispersion medium from the liquid, thereby refining the hole transport material,
wherein thus refined transport material is **characterized in that** when the hole transport material is dissolved or dispersed in a liquid so that the concentration thereof becomes 2.0 wt% , an amount of the anionic impurity of which content is the largest among the anionic impurities contained in the liquid is 2 ppm or less.

41. A method of refining a hole transport material to be used for a layer having the function of transporting holes in an organic EL device, the method comprising the steps of:
preparing a liquid in which a hole transport material is dissolved or dispersed in a solvent or a dispersion medium;
eliminating one or more kinds of cationic impurities contained in the liquid by means of eliminating means which separates or eliminates the cationic impurities, and then removing the solvent or dispersion medium from the liquid, thereby refining the hole transport material,
wherein thus refined transport material is **characterized in that** when the hole transport material is dissolved or dispersed in a liquid so that the concentration thereof becomes 2.0 wt%, an amount of the cationic impurity of which content is the largest among the cationic impurities contained in the liquid is 10 ppm or less.
